# EUROPEAN PATENT APPLICATION

(11) **EP 4 776 290 A2**
(43) Date of publication of application: **15.07.2026**
(21) Application number: 26180511.3
(22) Date of filing: 22.06.2023
(51) Int. Cl.: G11C 16/34

(54) **MEMORY DEVICE, MEMORY SYSTEM, AND OPERATING METHOD THEREOF**

(30) Priority: 24.06.2022 CN 202210729038
(62) Divisional of application: 23826576.3
(71) Applicant: Yangtze Memory Technologies Co., Ltd., Wuhan, Hubei 430000 (CN)
(72) Inventor: GUO, Xiaojiang, Wuhan, 430000 (CN)
(74) Representative: Lippert Stachow Patentanwälte Rechtsanwälte

(57) **Abstract**

A method of programming a memory device, a memory device and a memory system are provided. In the method, an N-th programming pulse is applied to a word line coupled to memory cells of the memory device with a target programming state being a programming state, wherein N is a positive integer. A N-th verification is performed on the memory cells, wherein the N-th verification includes a first sub-verification and an N-th second sub-verification. A (N+1)-th programming pulse is applied to the word line, based on an N-th second sub-result of the N-th second sub-verification. And after applying the (N+1)-th programming pulse to the word line, the memory device determines whether to perform a (N+1)-th verification based on a first sub-result of the first sub-verification.

## Description

### CROSS REFERENCE TO RELATED APPLICATION

The present disclosure claims priority to China Patent Application No. 202210729038.7, filed on June 24, 2022. The entire disclosure of the prior application is hereby incorporated by reference in its entirety.

### TECHNICAL FIELD

The present disclosure relates to semiconductor technology. In particular, this disclosure relates to a memory controller, a memory system, and an operating method thereof.

### BACKGROUND

A flash memory is widely used as a storage medium for portable electronic devices such as mobile phones, digital cameras, and the like. The flash memory typically includes one-transistor memory cells to achieve a high memory density, a high reliability, and a low power consumption. A threshold voltage of a memory cell can be changed by programming the memory cell through a charge storage structure (e.g., a floating gate or charge well) or a material (e.g., a phase change material or ferroelectric material) of the memory cell. The change of the threshold voltage of the memory cell can determine a data state (e.g., data value) of the memory cell.

To program a memory cell, one or more programming pulses can be applied to the memory cell. In related arts, after each programming pulse is applied to the memory cell, a respective programming verification can be performed on the memory cell. A number of the one or more programming pulses and a number of the corresponding one or more programming verifications are important factors for determining a time duration of programming the memory cell. Therefore, how to shorten the programming time duration under the premise of ensuring a high programming quality is an urgent problem to be solved.

### SUMMARY

Aspects of the disclosure provide a method of programming a memory device including memory cells. The method includes applying an N-th programming pulse to a word line coupled to the memory cells each with a target programming state being an i-th programming state, wherein i and N are positive integers. The method includes performing a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage. The method includes determining a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage. The method includes applying the (N+1)-th programming pulse to the word line. After applying the (N+1)-th programming pulse to the word line, the memory cells are determined to be successfully programmed to the i-th programming state based on the first sub-result indicating that a number of failed bits in the first sub-verification is less than a first preset value.

In an implementation, the memory cells include at least one of a single-level memory cell or a multi-level memory cell, and the target threshold voltage of the i-th programming state is highest among target threshold voltages of programming states corresponding to the single-level memory cell or the multi-level memory cell.

In an implementation, the memory cells include at least one of a three-level memory cell or a four-level memory cell, and the target programming states of the memory cells include a lowest programming state, one or more intermediate programming states, and a highest programming state, based on threshold voltages of the programming states, and wherein the i-th programming state is one of the one or more intermediate programming states.

In an implementation, the performing includes performing the first sub-verification on the memory cells based on a first sensing duration to obtain the first sub-result. The performing further includes performing the M-th second sub-verification on the memory cells based on a second sensing duration to obtain the M-th second sub-result, wherein the second sensing duration is greater than the first sensing duration.

In an implementation, the performing includes applying a first sub-verification voltage to the word line to perform the first sub-verification on the memory cells to obtain the first sub-result, wherein the first sub-verification voltage is equal to the preset voltage. The performing further includes applying a second sub-verification voltage to the word line to perform the M-th second sub-verification on the memory cells to obtain the M-th second sub-result, wherein the second sub-verification voltage is equal to the target threshold voltage.

In an implementation, the performing includes applying a first pre-charging voltage to a bit line coupled to the memory cells to perform the first sub-verification on the memory cells based on a preset sensing duration to obtain the first sub-result. The performing further includes applying a second pre-charging voltage to the bit line to perform the M-th second sub-verification on the memory cells based on the preset sensing duration to obtain the M-th second sub-result, wherein the second pre-charging voltage is greater than the first pre-charging voltage.

In an implementation, the threshold voltage of each of the first subset of the memory cells is less than the target threshold voltage based on the M-th second sub-result.

In an implementation, the method includes, determining a second subset of the memory cells to be performed with an (M+1)-th second sub-verification, based on the first sub-result indicating that the number of failed bits in the first sub-verification is greater than or equal to the first preset value. The method includes performing the (M+1)-th second sub-verification on the second subset of the memory cells to obtain an (M+1)-th second sub-result, wherein the (M+1)-th second sub-result indicates whether the threshold voltages of each of the second subset of the memory cells is less than the target threshold voltage.

In an implementation, the threshold voltage of each of the second subset of the memory cells is less than the preset voltage based on the first sub-result.

In an implementation, the method includes counting a number of failed bits in the (M+1)-th second sub-verification based on the (M+1)-th second sub-result to obtain a counting result. The method includes determining that the memory cells are successfully programmed to the i-th programming state based on the counting result being less than a second preset value.

In an implementation, the method includes determining one or more of the second subset of the memory cells to be programmed with an (N+2)-th programming pulse, based on the counting result being greater than or equal to the second preset value and a number of the applied programming pulses being less than a maximum number of programing pulses.

In an implementation, the method includes determining that the memory cells are unsuccessfully programmed to the i-th programming state based on the counting result being greater than or equal to the second preset value and a number of the applied programming pulses being equal to a maximum number of programming pulses.

In an implementation, the second preset value is less than or equal to the first preset value.

In an implementation, the performing includes performing the first sub-verification on the memory cells to obtain the first sub-result. The performing includes determining a third subset of the memory cells to be performed with the M-th second sub-verification, based on the first sub-result. The performing includes performing the M-th second sub-verification on the third subset of the memory cells to obtain the M-th second sub-result.

In an implementation, the performing includes performing the M-th second sub-verification on the memory cells to obtain the M-th second sub-result, determining a fourth subset of the memory cells to be performed with the first sub-verification, based on the M-th second sub-result, and performing the first sub-verification on the fourth subset of the memory cells to obtain the first sub-result.

In an implementation, the method includes counting the number of failed bits in the first sub-verification during applying the (N+1)-th programming pulse.

In an implementation, the number of failed bits is within a range allowed by an error correction mechanism.

In an implementation, the error correction mechanism uses an error correction code.

In an implementation, the method includes, in response to the first sub-result indicating that the number of failed bits in the first sub-verification is less than the first preset value, determining that a programming verification operation is not performed on the memory cells after applying the (N+1)-th programming pulse.

In an implementation, the first sub-verification is performed only one time during programming the memory cells to the i-th programming state.

Aspects of the disclosure provides a memory device including a memory cell array including memory cells and peripheral circuitry coupled to the memory cell array through word lines. The peripheral circuitry applies an N-th programming pulse to the memory cells each with a target programming state being an i-th programming state, wherein i and N are positive integers. The peripheral circuitry performs a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage. The peripheral circuitry determines a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage. The peripheral circuitry applies the (N+1)-th programming pulse to the word line, wherein the memory cells are determined to be successfully programmed to the i-th programming state after applying the (N+1)-th programming pulse to the word line, based on the first sub-result indicating that a number of failed bits in the first sub-verification is less than a first preset value.

Aspects of the disclosure provide a memory system including a memory device and a memory controller coupled to the memory device and configured to control the memory device. The memory device includes a memory cell array including memory cells and peripheral circuitry coupled to the memory cell array through word lines. The peripheral circuitry applies an N-th programming pulse to a word line coupled to the memory cells each with a target programming state being an i-th programming state, wherein i and N are positive integers. The peripheral circuitry performs a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage. The peripheral circuitry determines a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage. The peripheral circuitry applies the (N+1)-th programming pulse to the word line, wherein the memory cells are determined to be successfully programmed to the i-th programming state after applying the (N+1) programming pulse to the word line, based on the first sub-result indicating that a number of failed bits in the first sub-verification is less than a first preset value.

### BRIEF DESCRIPTION OF THE DRAWINGS

FIG. 1 shows a flowchart illustrating a programming process of a memory device according to implementations of the disclosure;
FIG. 2 illustrates a graph of a word line voltage applied to a word line coupled to a plurality of memory cells as a function of time according to implementations of the disclosure;
FIG. 3 shows a distribution diagram of threshold voltages of states of a three-level memory cell according to implementations of the disclosure;
FIG. 4 is a flow chart illustrating another programming process of memory device according to implementations of the disclosure;
FIG. 5 is a schematic diagram illustrating a memory device according to implementations of the disclosure;
FIG. 6 illustrates a partial view of a cross-section of an example memory cell array according to implementations of the disclosure;
FIG. 7 is a block diagram of a memory device including an array of memory cells and peripheral circuitry according to implementations of the disclosure;
FIG. 8 illustrates a block diagram of an example system with a memory device according to implementations of the disclosure;
FIG. 9A is a schematic diagram of a memory card according to implementations of the disclosure; and
FIG. 9B is a schematic diagram of a solid state drive according to implementations of the disclosure.

### DETAILED DESCRIPTION

Exemplary implementations of the present disclosure will be described in greater detail below with reference to the accompanying drawings. While exemplary implementations of the present disclosure are shown in the accompanying drawings, it should be appreciated that the present disclosure can be implemented in various forms and should not be limited by the specific implementations set forth herein. Rather, these implementations are provided to develop an understanding of the present disclosure and to communicate the scope of the present disclosure to those skilled in the art.

As described below, a great many specific details are given to provide an understanding of the present disclosure. However, the present disclosure can be implemented without one or more of these details. In other examples, some technical features that are well-known in the art are not described in order to avoid confusion with the present disclosure. That is, all features of actual implementations are not described here, and functions and structures that are well-known are not described in detail.

In the accompanying drawings, the dimensions of the layers, zones, and elements, as well as their relative dimensions, may be exaggerated for the sake of clarity. Throughout the drawings, the same numerals reference the same elements.

The terminology used herein is intended to describe specific implementations only and is not intended to be a limitation of the present disclosure.

In an example, when an element or a layer is referred to as "on", "adjacent to", "connected to", or "coupled to" other elements or layers, it may be directly on, adjacent to, connected to, or coupled to other elements or layers, or there may be interposed elements or layers. Conversely, when an element is referred to as "directly on," "directly adjacent to," "directly connected to," or "directly coupled to" other elements or layers, there are no interposed elements or layers.

In an example, the terms "first," "second," "third," and the like are used for distinguishing similar objects and are not necessarily used for describing a particular order or sequence. The terms "first," "second," "third," and the like may be used to describe various elements, parts, zones, layers, and/or portions, these elements, parts, zones, layers, and/or portions should not be limited by these terms. These terms are used only to distinguish one element, part, zone, layer, or portion from another element, part, zone, layer, or portion. Thus, without departing from the teachings of this disclosure, the first element, part, zone, layer, or portion discussed below may be represented as a second element, part, zone, layer, or portion. When a second element, part, zone, layer, or portion is discussed, it does not mean that a first element, part, zone, layer, or portion necessarily exists in the present disclosure.

In an example, the spatial relationship terms such as "under", "below", "the below", "on", "above", "the above", etc. may be used herein for ease of description, and thereby used to describe the relationship of one element or feature shown in the drawings with other elements or features.

In an example, in addition to the orientations shown in the drawings, the spatial relationship terminology can be intended to include different orientations of the device in use and operation. For example, if the device in the accompanying drawings is turned over, then the element or feature described as "under" or "below" other elements can be oriented to be "on" or "above" the other elements or features. Thus, the exemplary terms "under" and "below" may include both up and down orientations. The device may be oriented in other ways (rotated 90 degrees or in other orientations) and the spatial description terms used herein are interpreted accordingly.

In an example, the singular forms "a", "an", and "the/that" can also be intended to include the plural forms, unless the context clearly indicates otherwise.

In an example, the terms "comprising" and/or "including", when used in this specification, can identify the presence of the features, integers, steps, operations, components and/or parts, but do not exclude the presence of one or more other features, integers, steps, operations, components, and/or parts and/or components and/or groups.

In an example, the term "and/or" may include any and all combinations of the relevant listed items.

In an example, the term "layer" can refer to a portion of material that includes a region having a thickness. A layer may extend over the entirety of the underlying or overlying structure or may have an extent that is less than the extent of the underlying or overlying structure. Furthermore, a layer may be a region of a homogeneous or heterogeneous continuous structure having a thickness less than the thickness of the continuous structure. For example, a layer may be located between the top and bottom surfaces of the continuous structure, or a layer may be between any horizontal pair at the top and bottom surfaces of the continuous structure. The layers may extend horizontally, vertically and/or along inclined surfaces. The layer may comprise a plurality of sub-layers. For example, the interconnect layer may include one or more conductors and contact sub-layers (in which interconnect lines and/or via contacts are formed), and one or more dielectric sub-layers.

In order to provide a more detailed understanding of the features and technical aspects of implementations of the present disclosure, implementations of the present disclosure are described in detail below together with the accompanying drawings, which are provided for illustrative purposes only and are not intended to limit the implementations of the present disclosure.

Unless defined otherwise, all technical and scientific terms used herein have the same meaning as commonly understood by one of ordinary skill in the art to which this disclosure belongs. The terminology used herein is for the purpose of describing implementations of the disclosure only and is not intended to be limiting of the disclosure.

The technical means described in the implementations of the present disclosure may be arbitrarily combined without conflict.

A non-volatile memory device (e.g., NAND memory) has advantages of large capacity, high rewriting speed, and the like, and is suitable for storing a large amount of data. The NAND memory is widely used in embedded products, such as digital cameras, MP3 Walkman memory cards, small-sized USB disks, and the like.

The NAND memory can include single-level memory cells (SLC). Each single-level memory cell can store 1 bit of data and have two data states: low state (0) and high state (1), wherein a target threshold voltage of the low state is less than a target threshold voltage of the high state.

The NAND memory can include multi-level memory cells, such as two-level memory cells (MLC, in which one memory cell can store 2 bits of data), triple-level memory cells (TLC, also referred to as three-level memory cells, in which one memory cell can store 3 bits of data), quad-level memory cells (QLC, also referred to as four-level memory cells, in which one memory cell can stores 4 bits of data), and the like. Accordingly, the data states of the MLC, TLC, and QLC can be 4, 8, and 16, respectively.

Operations of the NAND memory can include an erasing operation, a programming (or writing) operation, and a reading operation. The erasing operation can be performed in a unit of a block, and the programming operation and the reading operation each can be performed in a unit of a page. The programming operation of the NAND memory can include operations such as pulse programming (e.g., by applying a programming pulse), programming verification (PV), and scanning verification results.

For the NAND memory, a programming duration t_{PROG} of the programming operation is an important factor for measuring the performance of the NAND memory. Therefore, researchers constantly dedicate on how to shorten the programming duration t_{PROG} of the programming operation without scarifying the programming quality. For example, a number of the programming pulses, a number of the programming verifications, a time duration of each programming verification, and a time duration of scanning the verification results are important factors in determining the programming duration t_{PROG} of the programming operation. If the number of the programming pulses and/or the number of the programming verifications can be reduced, the programming duration t_{PROG} of the programming operation can be effectively shortened.

For programming an SLC having one erasing state (E0) and one programming state (L1 state), a single large programming pulse can be applied to the SLC. That is, the programming of the SLC can be accomplished by applying only a single large programming pulse. Although this approach can have a short programming duration t_{PROG}, it may cause an over-programming for the SLC, thereby reducing a reliability of the SLC.

In order to achieve a better programming performance without scarifying the reliability, the programming of the SCL can be accomplished by applying two programming pulses. For example, after applying a first programming pulse to the SLC, a first programming verification can be performed on the SLC. Then, a second programming pulse can be applied to the SLC, followed by a second programming verification. Thus, the programming of the SLC can be completed by performing two cycles of pulse programming and programming verification. However, the programming duration t_{PROG} in this approach can be longer compared to the approach using the signal large programming pulse. If at least a part of the second programming verification can be omitted after the second programming pulse is applied, the programming duration t_{PROG} can be shortened.

A two-level memory cell can have one erasing state and three programming states. The highest programming state of the two-level memory cell is the programming state with the highest target threshold voltage.

A three-level memory cell can have one erasing state and seven programming states. The seven programming states can be sequentially marked as a first programming state L1, a second programming state L2, a third programming state L3, a fourth programming state L4, a fifth programming state L5, a sixth programming state L6, and a seventh programming state L7 according to an ascend order of target threshold voltages of these programming states. The highest programming state of the three-level memory cell is the seventh programming state L7.

This disclosure provides methods of programming a memory device including a plurality of memory cells.

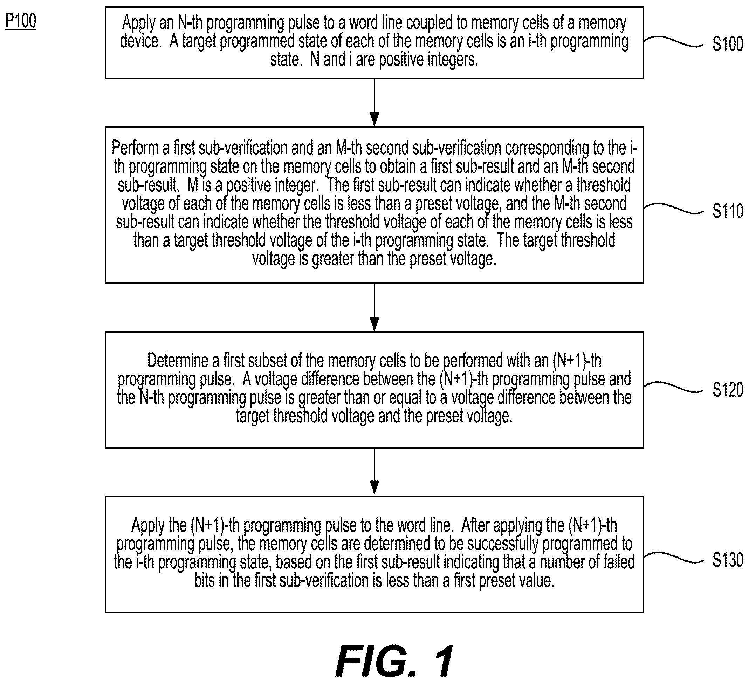

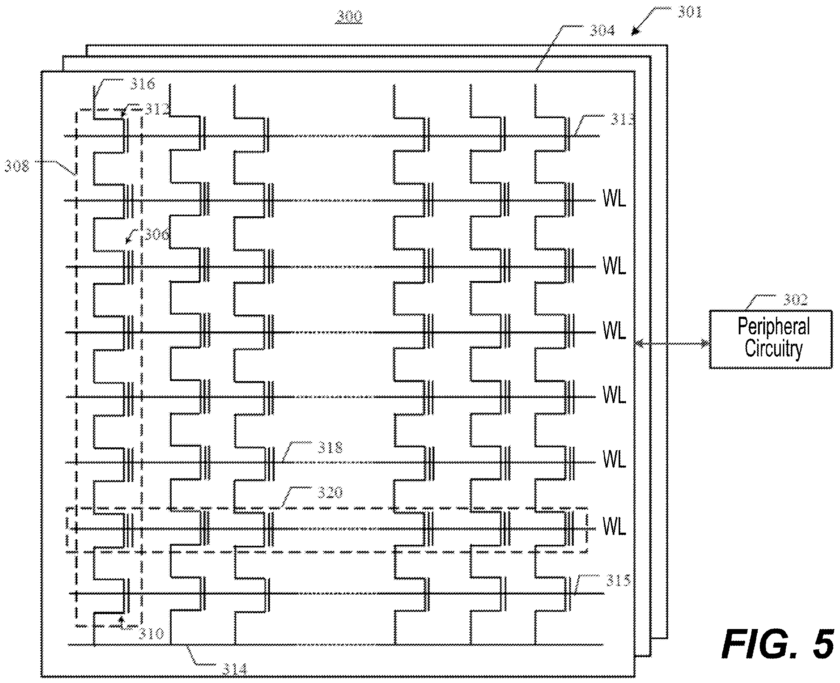

FIG. 1 shows a flowchart illustrating a programming process P100 of a memory device according to implementations of the disclosure. The programming process P100 can be performed by peripheral circuitry of a memory device, such as peripheral circuitry 302 of a memory device 300, as shown in FIG. 5. The programming process P100 may start at step S100.

At step S100, the programming process P100 can apply an N-th programming pulse to a word line coupled to memory cells of the memory device. A target programming state of each of the memory cells is an i-th programming state. N and i are positive integers. It is noted that the word line can be coupled to other memory cells that have one or more different target programming states. Then, the programming process P100 proceeds to step S110.

At step S110, the programming process P100 can perform a first sub-verification and an M-th second sub-verification corresponding to the i-th programming state on the memory cells to obtain a first sub-result and an M-th second sub-result. M is a positive integer. The first sub-result can indicate whether a threshold voltage of each of the memory cells is less than a preset voltage, and the M-th second sub-result can indicate whether the threshold voltage of each of the memory cells is less than a target threshold voltage of the i-th programming state. The target threshold voltage is greater than the preset voltage. Then, the programming process P100 proceeds to step S120.

At step S120, based on the M-th second sub-result, the programming process P100 can determine a first subset of the memory cells to be performed with an (N+1)-th programming pulse. A voltage difference between the (N+1)-th programming pulse and the N-th programming pulse is greater than or equal to a voltage difference between the target threshold voltage and the preset voltage. Then, the programming process P100 proceeds to step S130.

At step S130, the programming process P100 can apply the (N+1)-th programming pulse to the word line to program the first subset of the memory cells. After the (N+1)-th programming pulse is applied, the programming process can determine that the memory cells are successfully to be programmed to the i-th programming state, based on the first sub-result indicating that a number of failed bits in the first sub-verification is less than a first preset value. Then, the programming process P100 may terminate.

It is noted that each failed bit in the first sub-verification indicates that a threshold voltage of a memory cell corresponding to the respective bit is less than the preset voltage. Accordingly, the number of failed bits in the first sub-verification indicates a number of a subset of the memory cells. A threshold voltage of each of the subset of the memory cells is less than the preset voltage.

According to aspects of the disclosure, the N-th programming pulse can include an N-th programming voltage pulse or an N-th programming current pulse. The (N+1)-th programming pulse can include an (N+1)-th programming voltage pulse or an (N+1)-th programming current pulse. The (N+1)-th programming pulse is a next programming pulse applied after the N-th programming pulse. The first sub-verification and the M-th second sub-verification can be performed on the memory cells after the N-th programming pulse is applied and before the (N+1)-th programming pulse is applied.

In an implementation, at step S110, the first sub-verification and the M-th second sub-verification can be performed as two steps in one programming verification that is performed on the memory cells after the N-th programming pulse is applied and before the (N+1)-th programming pulse is applied.

In an implementation, a memory cell can be programmed and verified by applying programming pulses and performing programming verifications, respectively, to a word line coupled to the memory cell. The programming pulses can include the N-th programming pulse and the (N+1)-th programming pulse, and the programming verification of the memory cell can include the first sub-verification and the M-th second sub-verification.

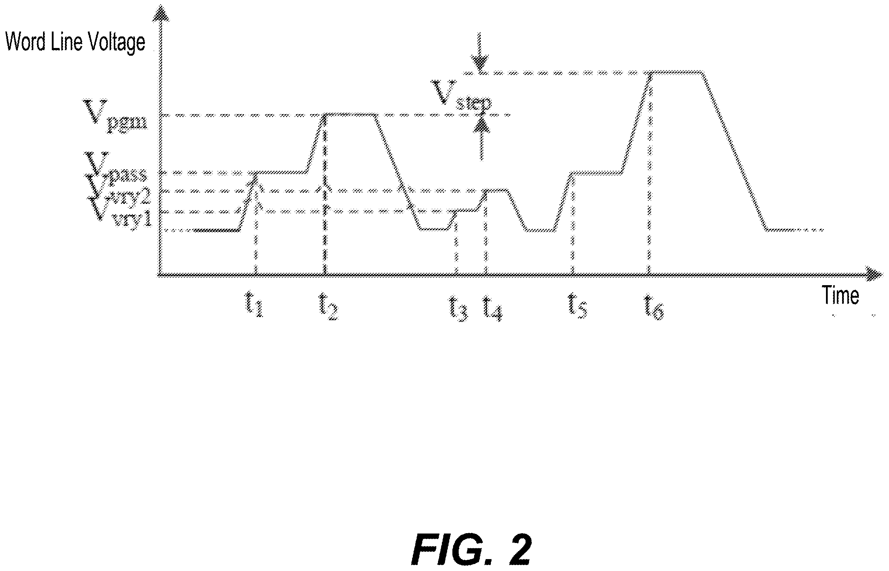

FIG. 2 illustrates a graph of a word line voltage applied to a word line coupled to a plurality of memory cells as a function of time according to implementations of the disclosure. As shown in FIG. 2, at time t₁, the word line voltage reaches a pass voltage Vₚₐₛₛ. At time t₂, the word line voltage is an N-th programming pulse V_{pgm}. At time t₃, the word line voltage reaches a first sub-verification voltage V_{vry1}, and the first sub-verification can be performed on the plurality of memory cells coupled to the word line. At time t₄, the word line voltage reaches a second sub-verification voltage V_{vry2}, and a second sub-verification can be performed on the plurality of memory cells coupled to the word line.

When the first sub-verification indicates that a threshold voltage of each of a subset of the plurality of memory cells is less than the preset voltage, a next programming pulse can be applied to the subset of the plurality of memory cells. Specifically, at time t₅, the word line voltage reaches the pass voltage Vₚₐₛₛ. At time t₆, the word line voltage reaches an (N+1)-th programming pulse, and a difference between voltage values of the (N+1)-th programming pulse and the N-th programming pulse is a step size Vₛₜₑₚ.

In an implementation, the plurality of memory cells can include a single-level memory cell. When N is 1, the N-th programming pulse is the first programming pulse applied to the single-level memory cell after the erasing operation is performed on the single-level memory cell.

In an implementation, the plurality of memory cells can include a multi-level memory cell, such as MLC, TLC, QLC, or the like. To program the highest programming state of the multi-level memory cell, the N-th programming pulse can be a programming pulse applied to the multi-level memory cell of which the target programming state is the highest programming state. The (N+1)-th programming pulse can be a next programming pulse after the N-th programming pulse is applied to the multi-level memory cell of which the target programming state is the highest programming state.

It is noted that, when the highest programming state is programmed by using the methods provided in the present disclosure, the number of the second sub-verifications can be reduced, and the programming duration t_{PROG} can be shortened.

In an implementation, the plurality of memory cells can include a three-level memory cell or a four-level memory cell. The target programming states of the plurality of memory cells can include a lowest programming state, one or more intermediate programming states, and a highest programming state, based on target threshold voltages of the programming states. A target threshold voltage of one of the one or more intermediate programming states is greater than a target threshold voltage of the lowest programming state and is less than a target threshold voltage of the highest programming state.

In an implementation, to program one of the one or more intermediate programming states of the three-level memory cell or the four-level memory cell, the N-th programming pulse can be a programming pulse applied to the three-level memory cell or the four-level memory cell of which the target programming state is the one of the one or more intermediate programming states. The (N+1)-th programming pulse can be a next programming pulse after the N-th programming pulse is applied to the three-level memory cell or the four-level memory cell of which the target programming state is the one of the one or more intermediate programming states.

It is noted that the methods provided in the present disclosure can also be used to program the one or more intermediate programming states or the highest programming state of a multi-level memory cell which can store more than 4 bits of data. It is also noted that the preset voltage (and/or the target threshold voltage) can be different for different target programming states.

It is noted that, to program the highest programming state of an MLC, a TLC, or a QLC, or to program an intermediate programming state of the TLC or the QLC, and when N is 1, the first programming pulse can be a first programming pulse applied after the erasing state , or can be a verification start pulse (or verification start loop) for verifying a memory cell to be programmed whose target programming state is an i-th programming state.

In an implementation, a three-level memory cell can have one erasing state and seven programming states. The erasing state can be denoted as L0, the seven programming states can be denoted as L1, L2, L3, L4, L5, L6, and L7 in a sequence from the first programed state to the seventh programming state.

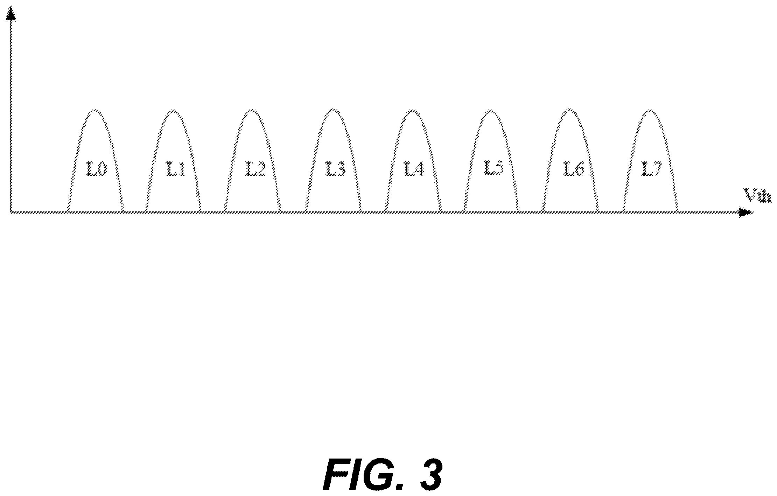

FIG. 3 shows a distribution diagram of threshold voltages of states of a three-level memory cell according to implementations of the disclosure. In FIG. 3, the threshold voltages of the states increase from L0 to L7.

Programming L1 to L7 can be started from the erasing state L0, and each programming state is verified in turn. The programming can be ended after all programming states are verified or a maximum count of the programming pulses is reached.

Table 1 shows an exemplary programming scheme for programming tri-level memory cells. The programming scheme can include a plurality of programming cycle s. In each programming cycle, a programming pulse can be applied, and a programming verification can be performed. It is noted that V in Table 1 indicates that a programming verification is performed, a blank space in Table 1 indicates that a programming cycle is not performed, and \ in Table 1 indicates that a programming verification is not performed.

As shown in Table 1, in the first programming cycle, the programming scheme can start to verify a memory cell with a target programming state being the L1 state. At the end of the fourth programming cycle, the programming scheme can stop verifying the memory cell with the target programming state being the L1 state. That is, a verification start pulse of the L1 state is the first programming pulse. At the end of the fourth programming cycle, i.e., after the fourth programming verification is performed, a first sub-result for the memory cell with the target programming state being the L1 state indicates that a number of failed bits in the first sub-verification is less than the first preset value. Accordingly, after the fifth programming pulse is applied thereto, the programming of the L1 state can be completed without a further programming verification.

In related arts, a programming verification is performed on the memory cell with the target programming state being the L1 state after the fifth programming pulse is applied. In the programming scheme provided in Table 1, the programming verification is not performed after the fifth programming pulse is applied when programming the L1 state, so that the programming duration t_{PROG} of the programming operation can be shortened.

As shown in Table 1, the L2 state is not verified during the first programming cycle. A programming verification of a memory cell with a target programming state being the L2 state can begin in the third programming cycle and end at the end of the sixth programming cycle. That is, the verification start pulse for the L2 state is the third programming pulse. At the end of the sixth programming cycle, i.e., after the sixth programming verification is performed, a first sub-result for the memory cell with the target programming state being the L2 state indicates that a number of failed bits in the first sub-verification is less than the first preset value. Accordingly, the programming of the L2 state can be passed (or successful) after the seventh programming pulse is applied, without a further programming verification. Programming of the L3 state to the L7 state can be similar to the programing of the L2 state and is not described in detail.

In an implementation, for a multi-level memory cell, at least two target states can be programmed simultaneously. When simultaneously programming the multiple target states, in a case where a number of failed bits in the first sub-verification of the lowest target programming state of the multiple target states is less than the first preset value, the programming of the lowest target programming state can be passed after a next programming pulse is applied. Accordingly, the first second sub-verification of a next target programming state in the multiple target states can be started.

As shown in Table 1, during the fifth and sixth program cycles, the L2 state is the lowest target programming state and the L3 state is not the lowest target state. Accordingly, the first sub-verification is performed on a memory cell with a target programming state being the L3 state, and the second sub-verification is not performed on the memory cell with the target programming state being the L3 state. At the end of the sixth programming cycle, a number of failed bits in the first sub-verification on the memory cell with the target programming state being the L2 state is less than the first preset value. Accordingly, during the seventh programming cycle, the seventh programming pulse is applied to the memory cell with the target programming state being the L2 state and the memory cells with the target states being the L3 state and the L4 state. The first second sub-verification on the L3 state can be started after the seventh programming pulse is applied.

It is noted that a verification start pulse for starting programming verification of any target programming state can be fixed or variable and is not limited in the disclosure.

**TABLE 1**

| Loop | 1 | 2 | 3 | 4 | 5 | 6 | 7 | 8 | 9 | 10 | 11 | 12 | 13 | 14 | 15 | 16 |
|---|---|---|---|---|---|---|---|---|---|---|---|---|---|---|---|---|
| L1 | V | V | V | V | | | | | | | | | | | | |
| L2 | | | V | V | V | V | | | | | | | | | | |
| L3 | | | | | V | V | V | V | | | | | | | | |
| L4 | | | | | | V | V | V | V | V | | | | | | |
| L5 | | | | | | | | V | V | V | V | V | | | | |
| L6 | | | | | | | | | | V | V | V | V | | | |
| L7 | | | | | | | | | | | | | V | V | V | |

Referring back to FIG. 3, a target threshold voltage of a memory cell is a voltage range of a target programming state of the memory cell. When a threshold voltage of the memory cell is increased to be within the voltage range of the target programming state, the memory cell can be considered to be programmed to the target programming state and the programming of the memory cell is completed.

It is noted that by performing the first sub-verification and the N-th second sub-verification, it can be determined whether a threshold voltage of a memory cell reaches two different voltages, respectively. Specifically, the first sub-verification is used to verify whether the threshold voltage of the memory cell reaches the preset voltage, and the N-th second sub-verification is used to verify whether the threshold voltage of the memory cell reaches the target threshold voltage.

The first sub-result is a verification result obtained by performing the first sub-verification on the memory cell after the N-th programming pulse is applied. The M-th second sub-result is a verification result obtained by performing M-th second sub-verification on the memory cell after the N-th programming pulse is applied.

The verification result of the programming verification can be stored in a page buffer. In an example, the verification result can be registered in a dedicated latch in the page buffer, which is used only for temporarily storing the verification result of the programming verification. In an example, the verification result can be registered in another latch in the page buffer, which can also be used to store program data, or program prohibition message, and the like.

In an implementation, the first sub-result can be used to count a number of failed bits in the first sub-verification. The number of failed bits in the first sub-verification is a number of memory cells each having a threshold voltage less than the preset voltage after the N-th programming pulse is applied to the memory cells. Based on the first sub-result, it can be obtained that first indication information that indicates the memory cells each having the threshold voltage less than the preset voltage after the N-th programming pulse is applied to the memory cells.

In an implementation, the M-th second sub-result can be used to count a number of failed bits in the M-th second sub-verification. The number of failed bits in the M-th second sub-verification is a number of memory cells each having a threshold voltage less than the target threshold voltage after the N-th programming pulse is applied to the memory cells. Based on the M-th second sub-result, it can be obtained that second indication information that indicates the memory cells each having the threshold voltage greater than or equal to the target threshold voltage after the N-th programming pulse is applied.

Based on the first sub-result and the M-th second sub-result, it can be obtained that third indication information that indicates the memory cells each having a threshold voltage greater than or equal to the preset voltage and less than the target threshold voltage after the N-th programming pulse is applied to the memory cells.

In an implementation, the first indication information, the second indication information, and the third indication information can include address information indicating an address of each of the memory cells.

In an implementation, at step S120, when a threshold voltage of a memory cell is less than the target threshold voltage, the programming process P100 can determine that an (N+1)-th programming pulse is to be applied on the memory cell. The memory cell is one of the first subset of the plurality of memory cells, each of which the (N+1)-th programming pulse is to be applied to.

In an implementation, at step S120, based on the M-th second sub-result, the programming process P100 can determine one or more of the memory cells. Threshold voltages of the one or more of the memory cells can reach the target threshold voltage after the N-th programming pulse is applied to the memory cells. The one or more of the memory cells can be considered to be successfully programmed (i.e., the programming of the one or more of the memory cells is passed). Accordingly, the (N+1)-th programming pulse is not applied to the one or more of the memory cells, in order to ensure that the one or more of the memory cells are not over-programmed, which is beneficial to improving the reliability.

In an implementation, at step S120, based on the M-th second sub-result, the programming process P100 can determine the first subset of the memory cells. The threshold voltages of the first subset of the memory cells do not reach the target threshold voltage after the N-th programming pulse is applied to the memory cells. The first subset of the memory cells can be considered to have not been successfully programmed. Accordingly, a next (i.e., the (N+1)-th) programming pulse is to be applied to the first subset of the plurality of memory cells.

In an implementation, when a number of failed bits is within a range allowed by an error correction mechanism that uses, for example, error correction code (ECC), at least a part of memory cells corresponding to the failed bits can be corrected by the error correction mechanism, improving the correctness of the data written into the memory device.

In an implementation, a range of the first preset value can be within the range allowed by the error correction mechanism, or the range of the first preset value can be slightly larger than the range allowed by the error correction mechanism.

When the value range of the first preset value is within the range allowed by the error correction mechanism, the number of failed bits in the first sub-verification indicated by the first sub-result can be within the range allowed by the error correction mechanism. The error correction mechanism can ensure a high accuracy of programming without performing a further programming verification, the programming can be considered to be passed, and the programming duration t_{PROG} can be shortened.

When the value range of the first preset value is slightly larger than the range allowed by the error correction mechanism, for a subset of the memory cells corresponding to the number of failed bits, each of the subset of memory cells can have a threshold voltage less than the preset voltage before the (N+1)-th programming pulse is applied and after the N-th programming pulse is applied. The threshold voltages of one or more of the subset of the memory cells can be increased to be greater than or equal to the target threshold voltage after the (N+1)-th programming pulse is applied. This is because the voltage difference between the (N+1)-th programming pulse and the N-th programming pulse is greater than or equal to the voltage difference between the target threshold voltage and the preset voltage. Accordingly, when the number of failed bits after the N-th programming pulse is applied is less than the first preset value, it is highly possible that the number of failed bits can be within the range allowed by the error correction mechanism after the (N+1)-th programming pulse is applied. The programming of the i-th programming state can be considered to be passed after the (N+1)-th programming is applied without performing a further programming verification, and thus the programming duration t_{PROG} can be shortened.

In an implementation, the voltage difference between the (N+1)-th programming pulse and the N-th programming pulse is greater than or equal to the voltage difference between the target threshold voltage and the preset voltage. For a subset of the memory cells each having a threshold voltage greater than or equal to the preset voltage and less than the target threshold voltage after the N-th programming pulse is applied, the threshold voltage of each of the subset of the memory cells can be increased to be greater than or equal to the target threshold voltage after the (N+1)-th programming pulse is applied.

In an implementation, for the subset of the memory cells having threshold voltages greater than or equal to the preset voltage and less than the target threshold voltage after the N-th programming pulse is applied, the threshold voltages of a very small portion of the subset of the memory cells may remain to be less than the target threshold voltage after the (N+1)-th programming pulse is applied, possibly due to an interference such as programming noise.

For the subset of the memory cells having threshold voltages greater than or equal to the preset voltage and less than the target threshold voltage after the N-th programming pulse is applied, it is highly possible to successful program the memory cells after the (N+1)-th programming pulse is applied. That is, the probability of successful programming of the memory cells is high when the programming verification of the memory cells is performed after the (N+1)-th programming pulse is applied. Accordingly, the programming verification does not need to be performed on the memory cells after the (N+1)-th programming pulse is applied. The number of the memory cells that need to be verified after the (N+1)-th programming pulse is applied can be reduced, the time duration of the programming verification can be shortened, and the programming duration t_{PROG} can also be shortened.

According to aspects of the disclosure, by setting the voltage difference between the (N+1)-th programming pulse and the N-th programming pulse being greater than or equal to the voltage difference between the target threshold voltage and the preset voltage, for the subset of the memory cells each having a threshold voltage between the preset voltage and the target threshold voltage, the threshold voltages of at least one of the subset of the memory cells can be increased to reach the target threshold voltage after the (N+1)-th programming pulse is applied, so as to complete the programming of at least one of the subset of the memory cells.

It is noted that, when the voltage difference between the (N+1)-th programming pulse and the N-th programming pulse is greater than the voltage difference between the target threshold voltage and the preset voltage, to reduce the probability of over-programming a memory cell, a voltage value of the (N+1)-th programming pulse can be adjusted.

In the implementation, after the N-th programming pulse is applied, it can be determined that the subset of the memory cells each having the threshold voltage between the preset voltage and the target threshold voltage based on the first sub-result of the first sub-verification and the M-th second sub-result of the M-th second sub-verification. Because the voltage difference between the (N+1)-th programming pulse and the N-th programming pulse is greater than or equal to the voltage difference between the target threshold voltage and the preset voltage, after the (N+1)-th programming pulse is applied, the probability that the threshold voltages of the subset of the memory cells reach the target threshold voltage after the (N+1)-th programming pulse is applied can be improved, and the probability of over-programming can be reduced. After the (N+1)-th programming pulse is applied, the programming verification does not need to be performed on the subset of the memory cells. When the first sub-result indicates that the number of failed bits in the first sub-verification is less than the first preset value, the programming of the i-th programming state can be determined to be passed. Accordingly, the programming methods provided in the present disclosure can reduce the number of programming verifications without sacrificing the reliability and can effectively shorten programming duration t_{PROG}.

In an implementation, at step S110, after applying the N-th programming pulse, the programming process P100 can apply a first sub-verification voltage to the word line coupled to the memory cells to perform the first sub-verification on the memory cells to obtain the first sub-result. After applying the N-th programming pulse, the programming process P100 can apply a second sub-verification voltage to the word line coupled to the memory cells to perform the M-th second sub-verification on the memory cells to obtain the M-th second sub-result. The second sub-verification voltage is greater than the first sub-verification voltage.

In an implementation, the first sub-verification can be performed on the memory cells before the M-th second sub-verification. Specifically, at step S110, the programming process P100 can perform the first sub-verification on the memory cells to obtain the first sub-result, determine a third subset of the memory cells on which the M-th second sub-verification is to be performed based on the first sub-result, and perform the M-th second sub-verification on the third subset of the memory cells to obtain the M-th second sub-result.

In an implementation, if a memory cell does not pass the first sub-verification, a threshold voltage of the memory cell is less than the preset voltage. Because the preset voltage is less than the target threshold voltage, the threshold voltage of the memory cell that does not pass the first sub-verification is less than the target threshold voltage. Thus, the M-th second sub-verification is not to be performed on the memory cell.

In an implementation, if a memory cell passes the first sub-verification, a threshold voltage of the memory cell is greater than or equal to the preset voltage. Because the preset voltage is less than the target threshold voltage, the magnitude relationship between the threshold voltage of the memory cell and the target threshold voltage needs to be further verified. Thus, the M-th second sub-verification is to be performed on the memory cell.

In related arts, after the N-th programming pulse is applied, the first sub-verification and the M-th second sub-verification are performed on all the memory cells with the target programming states being the i-th programming state. In the methods provided in the present disclosure, a number of memory cells that the M-th second sub-verification is to be applied on can be reduced, the verification time can be further shortened, and the programming duration t_{PROG} can also be shortened.

In an implementation, the M-th second sub-verification can be performed on the memory cells before the first sub-verification. Based on the result of the M-th second sub-verification, it can be determined that a fourth subset of the memory cells that the first sub-verification is to be performed on. For example, at step S110, the programming process P100 can perform the M-th second sub-verification on the memory cells to obtain the M-th second sub-result, determine the fourth subset of the memory cells that the first sub-verification is to be performed on based on the M-th second sub-result, and perform the first sub-verification on the fourth subset of the memory cells to obtain the first sub-result.

In an implementation, if a memory cell passes the M-th second sub-verification, a threshold voltage of the memory cell is greater than or equal to the target threshold voltage. Because the target threshold voltage is greater than the preset voltage, the threshold voltage of the memory cell that passes the M-th second sub-verification is greater than the preset voltage. Thus, the first sub-verification is not to be performed on the memory cell.

In an implementation, if a memory cell does not pass the N-th second sub-verification, a threshold voltage of the memory cell is less than the target threshold voltage. Because the target threshold voltage is greater than the preset voltage, the magnitude relationship between the threshold voltage of the memory cell that does not pass the M-th second sub-verification and the preset voltage needs to be further verified. Thus, the first sub-verification is to be performed on the memory cell.

In related arts, after the N-th programming pulse is applied, the first sub-verification and the M-th second sub-verification are performed on all the memory cells with the target programming states being the i-th programming state. In the methods provided in the present disclosure, a number of memory cells that the first sub-verification is to be performed on can be reduced, the verification time can be further shortened, and the programming duration t_{PROG} can also be shortened.

In related arts, the (N+1)-th programming verification is applied on all the memory cells, taking a long time and requiring a large power to establish programming verification conditions after a programming pulse is applied. In the methods provided in the present disclosure, although an additional time may be required for setting the word line, a number of the second sub-verifications can be reduced by flexibly setting start times of the first sub-verification and the second sub-verification, and the time for setting the word line can be thus reduced. Therefore, the programming duration t_{PROG} can be shorten and the programming power can be reduced.

In an implementation, when programming a single-level memory cell, a voltage of a word line coupled to the single-level memory cell only needs to be changed during the first programming verification (i.e., when the first sub-verification and the first second sub-verification are performed), further reducing the programming duration t_{PROG} and programming power.

In an implementation, at step S110, after applying the N-th programming pulse, the programming process P100 can apply a first pre-charging voltage to a bit line coupled to the memory cells and perform the first sub-verification on the memory cells based on a preset sensing duration to obtain the first sub-result. After applying the N-th programming pulse, the programming process P100 can apply a second pre-charging voltage to the bit line coupled to the memory cells and perform the N-th second sub-verification on the memory cells based on the preset sensing duration to obtain the M-th second sub-result. The second pre-charge voltage is greater than the first pre-charge voltage.

It is noted that the same sensing duration can be used for performing the first sub-verification and the M-th second sub-verification on the memory cells by applying different pre-charge voltages to the bit line coupled to the memory cells, respectively.

In an implementation, at step S110, after applying the N-th programming pulse, the programming process P100 can perform the first sub-verification on the memory cells based on a first sensing duration to obtain the first sub-result. After applying the N-th programming pulse, the programming process P100 can perform the M-th second sub-verification on the plurality of memory cells based on a second sensing duration to obtain the M-th second sub-result. The second sensing duration is greater than the first sensing duration.

In an implementation, a programming verification can include a pre-charging phase, a sensing phase, and a reading phase. In the pre-charging phase, a pre-charging voltage can be applied to a bit line coupled to a memory cell. After a sensing duration after applying the pre-charging voltage, the bit line voltage or the bit line current can be sensed. The programming verification of the memory cell can be performed based on the sensed bit line voltage or bit line current.

In an implementation, the bit line voltage or bit line current can be sensed by sensing circuitry in peripheral circuitry such as peripheral circuitry 302 in FIG. 5. The sensing circuitry can be located in a page buffer (e.g., page buffer 504) of the peripheral circuitry.

A sensing duration is a duration of the sensing phase and can be the preset sensing duration, the first sensing duration, or the second sensing duration. Through the pre-charging phase, a voltage of the bit line is pre-charged to a preset level. After the pre-charging phase, the voltage level of the bit line can vary during the sensing phase, depending on a threshold voltage of the memory cell coupled to the bit line. After the sensing duration, i.e., after the sensing phase, the reading can be performed based on the voltage level of the bit line to determine the threshold voltage of the memory cell coupled to the bit line. Then, the programming verification of the memory cell can be performed based on the determined threshold voltage of the memory cell.

In an implementation, a first sub-verification of a memory cell can be performed based on a short first sensing duration and a second sub-verification of the memory cell can be performed based on a long second sensing duration. Accordingly, it is not necessary to set different voltages for a word line and/or a bit line coupled to the memory cell, so that the time duration of the programming verification can be shortened, and the programming duration t_{PROG} can be reduced.

In an implementation, a voltage difference between the bit line voltage sensed based on the first sensing period and the bit line voltage sensed based on the second sensing period can be small. In order to increase the voltage difference between the bit line voltage sensed based on the first sensing period and the bit line voltage sensed based on the second sensing period, a large N-th programming pulse can be applied, and the step size between the (N+1)-th programming pulse and the N-th programming pulse can be small.

In an implementation, after the (N+1)-th programming pulse is applied, the first sub-result indicates that a number of failed bits in the first sub-verification is greater than or equal to the first preset value. Based on the first sub-result, the programming process P100 can determine a second subset of the memory cells that a programming verification is to be applied on after the (N+1)-th programming pulse is applied. The programming process P100 can perform the (M+1)-th second sub-verification on the second subset of the memory cells to obtain the (M+1)-th second sub-result.

In an implementation, when a threshold voltage of a memory cell is less than the preset voltage, the programming process P100 can determine that a programming verification is to be applied on the memory cell after the (N+1)-th programming pulse is applied. When the threshold voltage of the memory cell is greater than or equal to the preset voltage, the programming process P100 can determine that a programming verification is not to be applied on the memory cell after the (N+1)-th programming pulse is applied.

Based on the first sub-result, a subset of memory cells having threshold voltages not reaching the preset voltage after the N-th programming pulse is applied can be determined. After the (N+1)-th programming pulse is applied to the subset of the memory cells, there can be at least one of the subset of the memory cells (e.g., a memory cell having the threshold voltages slightly less than the preset voltage after the N-th programming pulse is applied) having the threshold voltages reaching the target threshold voltage, or there can be at least another subset of the memory cells having the threshold voltages less than the target threshold voltage.

In an implementation, after the (N+1)-th programming pulse is applied, the first sub-result indicates that the number of failed bits in the first sub-verification is greater than or equal to the first preset value. A programming verification can be performed on the subset of the memory cells having the threshold voltages not reaching the preset voltage after the N-th programming pulse is applied. The programming verification of the subset of the memory cells can be performed after the (N+1)-th programming pulse is applied.

Based on the first sub-result, a subset of the memory cells having the threshold voltages reaching the preset voltage after the N-th programming pulse is applied can be determined. Because the voltage difference between the (N+1)-th programming pulse and the N-th programming pulse is greater than or equal to the voltage difference between the target threshold voltage and the preset voltage, it is highly possible that the threshold voltages of the subset of the memory cells can reach the target threshold voltage after the (N+1)-th programming pulse is applied. Accordingly, a programming verification is not performed on the subset of the memory cells after the (N+1)-th programming pulse is applied.

According to aspects of the disclosure, for the subset of the memory cells having the threshold voltages reaching the preset voltage after the N-th programming pulse is applied, the successful programming of the subset of the memory cells after the (N+1)-th programming pulse is applied can be predicted based on the first sub-result obtained after the N-th programming pulse is applied.

In an implementation, based on the first sub-result, the programming process P100 can count the number of failed bits in the first sub-verification to obtain a first counting result.

In an implementation, at step S130, after the (N+1)-th programming pulse is applied, and the first counting result is less than the first preset value, the programming process P100 can determine that the programming of the i-th programming state is passed. When the first counting result is greater than or equal to the first preset value, after the (N+1)-th programming pulse is applied, the programming process P100 can perform (M+1)-th second sub-verification on the second subset of the memory cells after the (N+1)-th programming pulse is applied, to obtain (M+1)-th second sub-result.

The first counting result includes the number of the bits or the memory cells having threshold voltages less than the preset voltage after the N-th programming pulse is applied.

In an implementation, a binary coding can be used to indicate whether a threshold voltage of a memory cell is less than the preset voltage. For example, zero (0) can indicate that the threshold voltage of the memory cell is less than the preset voltage, and one (1) can indicate that the threshold voltage of the memory cell is greater than or equal to the preset voltage. Alternatively, one (1) can indicate that the threshold voltage of the memory cell is less than the preset voltage, and zero (0) can indicate that the threshold voltage of the memory cell is greater than or equal to the preset voltage. A person skilled in the art may select an appropriate manner to indicate whether the memory cell is programmed or not according to practical situations, which is not limited in the present disclosure.

In an implementation, the programming process P100 can count the number of failed bits in the first sub-verification based on the first sub-result to obtain the first counting result when the (N+1)-th programming pulse is applied.

In an implementation, after each programming verification, a counting for the verification result can be performed. In an example, the counting can include the number of memory cells that fail in the programming verification and can be referred to as failed bit count (FBC). In related arts, the counting of the number of failed bits is performed between the current programming pulse and the next programming pulse, and takes an extra time, resulting in a long program time.

In an implementation, applying the (N+1)-th programming pulse can include preparing the (N+1)-th programming pulse and executing the (N+1)-th programming pulse. Preparing the (N+1)-th programming pulse is to prepare programming data for executing the (N+1)-th programming pulse and to apply a pass voltage (Vpass) to a word line coupled to a memory cell to be programmed. Executing the (N+1)-th programming pulse is to control a voltage level of a bit line coupled to the memory cell in response to the programming data and to apply the (N+1)-th programming pulse to the word line coupled to the memory cell.

In an implementation, after preparing the (N+1)-th programming pulse, that is, after the pass voltage is applied to the word line coupled to the memory cell, the first sub-result can be obtained during executing the (N+1)-th programming pulse, and the number of the failed bits in the first sub-verification can be counted, so as to obtain the first counting result.

According to aspects of the disclosure, the number of the failed bits in the first sub-verification can be counted during applying the (N+1)-th programming pulse. Obtaining the first counting result during the programming operation does not take extra time, the programming duration t_{PROG} of the programming operation can be shortened, and the programming efficiency can be improved.

In an implementation, the counting of the number of the failed bits in the first sub-verification after the N-th programming pulse is applied can be performed during applying the (N+1)-th programming pulse, reducing a logic overhead.

In an implementation, based on the (M+1)-th second sub-result, the programming process P100 can count the number of the failed bits in the (M+1)-th second sub-verification to obtain a second counting result. When the second counting result is less than a second preset value, the programming process P100 can determine that the programming of the i-th programming state is passed. When the second counting result is greater than or equal to the second preset value and the number of the applied programming pulses is less than a maximum number of programming pulses, the programming process P100 can determine a subset of the memory cells that the (N+2)-th programming pulse is to be applied on based on the (M+1)-th second sub-result. When the second counting result is greater than or equal to the second preset value and the number of the applied programming pulses is equal to the maximum number of programming pulses, the programming process P100 can determine that the programming of the i-th programming state fails.

The second counting result can include the number of the failed bits after applying a programming pulse.

In an implementation, whether a threshold voltage of a memory cell is less than the preset voltage can be represented by a binary code.

In an implementation, a range of the second preset value is within the range allowed by the error correction mechanism.

In an implementation, when the number of the failed bits is within the range allowed by the error correction mechanism, at least a part of the memory cells corresponding to the failed bits can be corrected by the error correction mechanism, so that correct data can be read from the memory device.

In an implementation, the range of the second preset value is within the range allowed by the error correction mechanism. When the number of the failed bits is less than the second preset value, the memory cells corresponding to the failed bits can be corrected by the error correction mechanism, and the good programming efficiency can be ensured.

In an implementation, the second preset value is less than or equal to the first preset value.

In an implementation, the (N+1)-th programming pulse is applied to the first subset of the memory cells having the threshold voltages less than the target threshold voltage, so that the threshold voltages of at least one of the first subset of the memory cells can be increased to reach the target threshold voltage. The (N+1)-th programming pulse is applied after the first sub-verification. Accordingly, after the (N+1)-th programming pulse is applied, the number of memory cells with programming failures can be less than the first counting result. Accordingly, the first preset value can be set slightly greater than the second preset value, in order to determine whether the programming of the i-th programming state is passed or not.

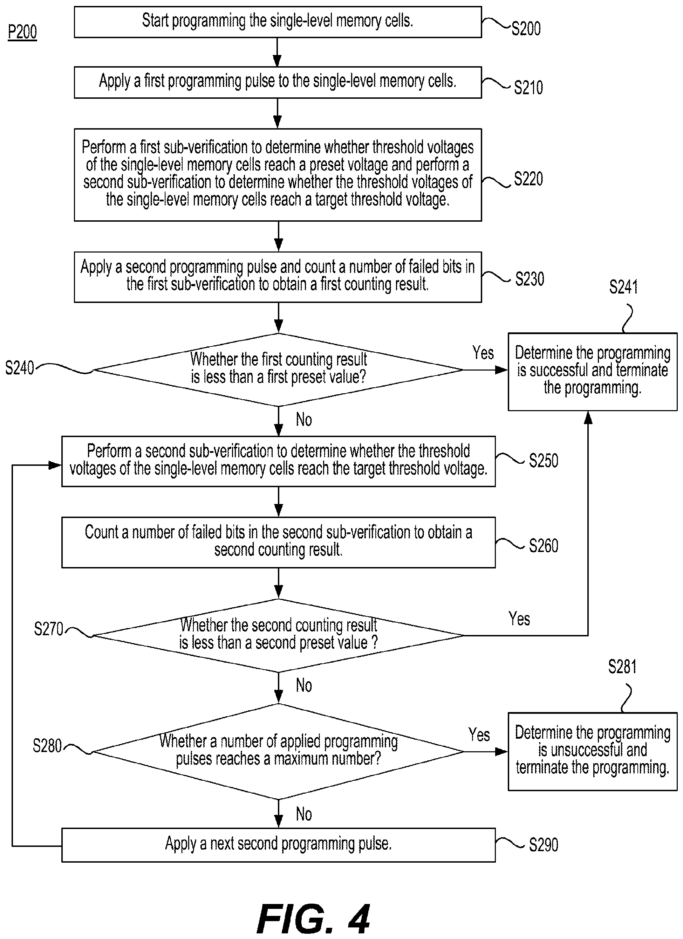

FIG. 4 is a flow chart illustrating another programming process P200 of a memory device according to implementations of the disclosure. The programming process P200 can be applied to single-level memory cells and may start from step S200.

At step S200, the programming process P200 can start programming the single-level memory cells. Then, the programming process P200 proceeds to step S210.

At step S210, the programming process P200 can apply a first programming pulse to the single-level memory cells. Then, the programming process P200 proceeds to step S220.

At step S220, the programming process P200 can perform a first sub-verification to determine whether threshold voltages of the single-level memory cells reach a preset voltage and perform a second sub-verification to determine whether the threshold voltages of the single-level memory cells reach a target threshold voltage. Then, the programming process P200 proceeds to step S230.

At step S230, the programming process P200 can apply a second programming pulse and count a number of failed bits in the first sub-verification to obtain a first counting result. Then, the programming process P200 proceeds to step S240.

At step S240, the programming process P200 can determine whether the first counting result is less than a first preset value or not. When the first counting result is less than the first preset value, the programming process P200 proceeds to step S241. When the first counting result is greater than or equal to the first preset value, the programming process P200 proceeds to step S250.

At step S241, the programming process P200 can determine the programming is successful and terminate the programming.

At step S250, the programming process P200 can perform a second sub-verification to determine whether the threshold voltages of the single-level memory cells reach the target threshold voltage. Then, the programming process P200 proceeds to step S260.

At step S260, the programming process P200 can count a number of failed bits in the second sub-verification to obtain a second counting result. Then, the programming process P200 proceeds to step S270.

At step S270, the programming process P200 can determine whether the second counting result is less than a second preset value or not. When the second counting result is less than the second preset value, the programming process P200 proceeds to step S241. When the second counting result is greater than or equal to the second preset value, the programming process P200 proceeds to step S280.

At step S280, the programming process P200 can determine whether a number of applied programming pulses reaches a maximum number of applied programming pulses. When the number of the applied programming pulses reaches the maximum number, the programming process P200 proceeds to step S281. When the number of the applied programming pulses does not reach the maximum number, the programming process P200 proceeds to step S290.

At step S281, the programming process P200 can determine the programming is unsuccessful and terminate the programming.

At step S290, the programming process P200 can apply a next second programming pulse.

It is noted that, after step S210, threshold voltages of one or more of the single-level memory cells can be the greater than or equal to the preset voltage and less than the target threshold voltage. The voltage difference between the second programming pulse applied at step S230 and the first programming pulse applied at step S210 is large enough to ensure that the threshold voltages of the one or more of the single-level memory cells can be increased to reach the target threshold voltage after step S230. For example, the voltage difference between the second programming pulse applied at step S230 and the first programming pulse applied at step S210 is greater than or equal to the voltage difference between the target threshold voltage and the preset voltage.

At step S240, the first counting result is a result of counting a number of a subset of the single-level memory cells each having the threshold voltage less than the preset voltage after the first programming pulse is applied. The voltage difference between the second programming pulse applied at step S230 and the first programming pulse applied at step S210 is greater than or equal to the voltage difference between the target threshold voltage and the preset voltage. After step S230, when the first counting result is less than the first preset value, the programming of the single-level memory cells can be considered to be passed, and the second sub-verification can be directly omitted, thereby shortening the programming duration t_{PROG}.

At step S280, the maximum number can be set based on an implementation. For example, the maximum number of the applied programming pulses can be set as 2, 3, or 4.

FIG. 5 is a schematic diagram illustrating a memory device 300 according to implementations of the disclosure. The memory device 300 can include a memory cell array 301 including a plurality of memory cell rows and a plurality of word lines 318 respectively coupled to the plurality of memory cell rows. The memory device 300 can include peripheral circuitry 302 coupled to the plurality of word lines 318 and configured to perform a programming operation on a selected row of memory cell rows. The selected row is coupled to a selected word line. To perform the programming operation, the peripheral circuitry 302 is configured to perform a programming method according to any of the implementations of the present disclosure

The memory cell array 301 can be a NAND flash memory cell array, in which memory cells 306 are provided in a form of an array of NAND memory strings 308, and each NAND memory string 308 extends vertically above a substrate (not shown). In an implementation, each NAND memory string 308 includes multiple memory cells 306 coupled in series and stacked vertically. Each memory cell 306 can hold a continuous analog value, e.g., a voltage or charge, that depends on a number of electrons trapped within an area of the respective memory cell 306. Each memory cell 306 can be a floating gate type memory cell including a floating gate transistor or a charge trapping type memory cell including a charge trapping transistor.

In an implementation, each memory cell 306 can include: a single level memory cell having two possible memory states and therefore capable of storing one bit of data. For example, a first memory state "0" can correspond to a first voltage range, and a second memory state "1" can correspond to a second voltage range.

In an implementation, memory cells 306 can include multi-level memory cells, such as MLC, TLC, QLC, or the like. When the memory cell 306 is a multi-level memory cell, the peripheral circuitry is configured to: when the highest programming state of the multi-level memory cell is programmed, the programming method provided in the disclosure is executed.

When the memory cell 306 is a three-level memory cell, a four-level memory cell, or the like, the peripheral circuitry is configured to: when the intermediate state of the three-level memory cell or the four-level memory cell is programmed, the programming method provided in the disclosure is executed.

As shown in FIG. 5, each NAND memory string 308 can include a source select gate (SSG) 310 at a source end and a drain select gate (DSG) 312 at a drain end. The source select gate 310 and the drain select gate 312 can be configured to activate a selected NAND memory string 308 (column of the array) during read and program operations.

In an implementation, the sources of the NAND memory strings 308 in the same block 304 are coupled by the same source line (SL) 314 (e.g., a common SL). In an implementation, all NAND memory strings 308 in the same block 304 can have an array common source (ACS).

In an implementation, the drain select gate 312 of each NAND memory string 308 is coupled to a respective bit line 316, from which bit line 316 data can be read or written via an output bus (not shown).

In an implementation, each NAND memory string 308 is configured to be selected by applying a select voltage (e.g., higher than the threshold voltage of the transistor having the drain select gate 312) or a deselect voltage (e.g., 0V) to the respective drain select gate 312 via one or more drain select gate lines 313.

In an implementation, each NAND memory string 308 is configured to be selected or deselected by applying a select voltage (e.g., above the threshold voltage of the transistor having the source select gate 310) or a deselect voltage (e.g., 0V) to the respective source select gate 310 via one or more source select gate lines 315.

As shown in FIG. 5, the NAND memory strings 308 can be organized into a plurality of blocks 304, each of the plurality of blocks 304 can have a common source line 314 (e.g., coupled to ground). In an implementation, each block 304 is a basic unit of data for an erase operation, i.e., all memory cells 306 on the same block 304 are erased at the same time. In an example, the erase operation can be performed at a half block level, at a quarter block level, or at any suitable fraction of a number of blocks or blocks. The memory cells 306 of adjacent NAND memory strings 308 can be coupled by word lines 318, the word lines 318 selecting which row of memory cells 306 is affected by read and program operations.

In an embodiment, each word line 318 is coupled to a page 320 of memory cells 306, and the page 320 is a basic unit of data for a program operation. A size of the page 320 in bits can be related to a number of the NAND memory strings 308 coupled by a word line 318 in one block 304. Each word line 318 can include a plurality of control gates (gate electrodes) at each memory cell 306 in a respective page 320 and a gate line coupling the control gates. One memory cell row can represent a plurality of memory cells 306 located in the same page 320.

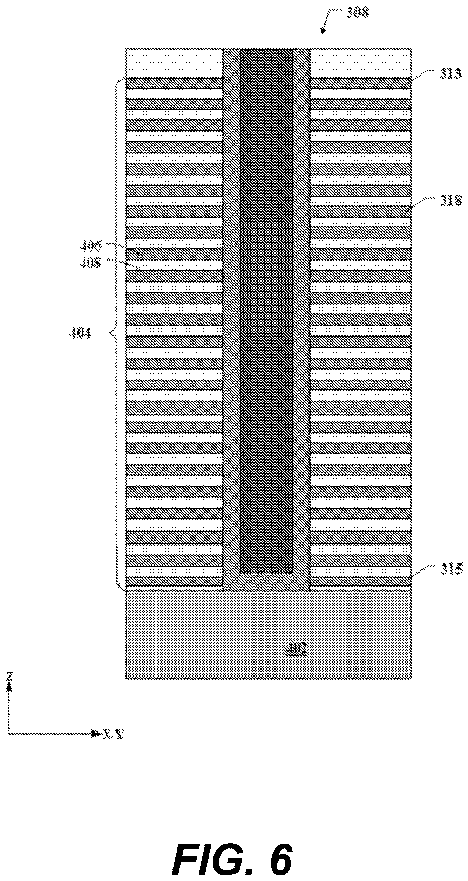

FIG. 6 illustrates a partial view of a cross-section of an example memory cell array according to implementations of the disclosure. The memory cell array can be the memory cell array 301 and can include the NAND memory strings 308. The NAND memory strings 308 can extend vertically through a memory stack 404 above a substrate 402. The substrate 402 can include silicon (e.g., single crystal silicon), silicon germanium (SiGe), gallium arsenide (GaAs), germanium (Ge), silicon-on-insulator (SOI), germanium-on-insulator (GOI), or any other suitable material.

The memory stack 404 can include alternating gate conductive layers 406 and gate-to-gate dielectric layers 408. A number of pairs of the gate conductive layers 406 and the gate-to-gate dielectric layers 408 in the memory stack 404 can determine the number of memory cells 306 in the memory cell array 301.

The gate conductive layer 406 can include a conductive material including, but not limited to, tungsten (W), cobalt (Co), copper (Cu), aluminum (Al), polysilicon, doped silicon, silicide, or any combination thereof. In an implementation, each gate conductive layer 406 can include a metal layer, for example, a tungsten layer. In an implementation, each gate conductive layer 406 can include a doped polysilicon layer. Each gate conductive layer 406 can include a control gate surrounding a memory cell 306 and can extend laterally at the top of the memory stack 404 as a drain select gate line 313, laterally at the bottom of the memory stack 404 as a source select gate line 315, or laterally between the drain select gate line 313 and the source select gate line 315 as a word line 318.

Although not shown in FIG. 6, additional components of the memory cell array 301 can be formed, including but not limited to gate line apertures/source contacts, local contacts, interconnect layers, and the like.

Referring back to FIG. 5, the peripheral circuitry 302 can be coupled to the memory cell array 301 through the bit lines 316, the word lines 318, the source lines 314, the source select gate lines 315, and the drain select gate lines 313. The peripheral circuitry 302 can include any suitable analog, digital, and mixed-signal circuitry for facilitating operation of the memory cell array 301 by applying and sensing voltage and/or current signals to and from each target memory cell 306 via the bit lines 316, the word lines 318, the source lines 314, the source select gate lines 315, and the drain select gate lines 313. The peripheral circuitry 302 can include various types of peripheral circuitry formed using metal-oxide-semiconductor (MOS) technology.

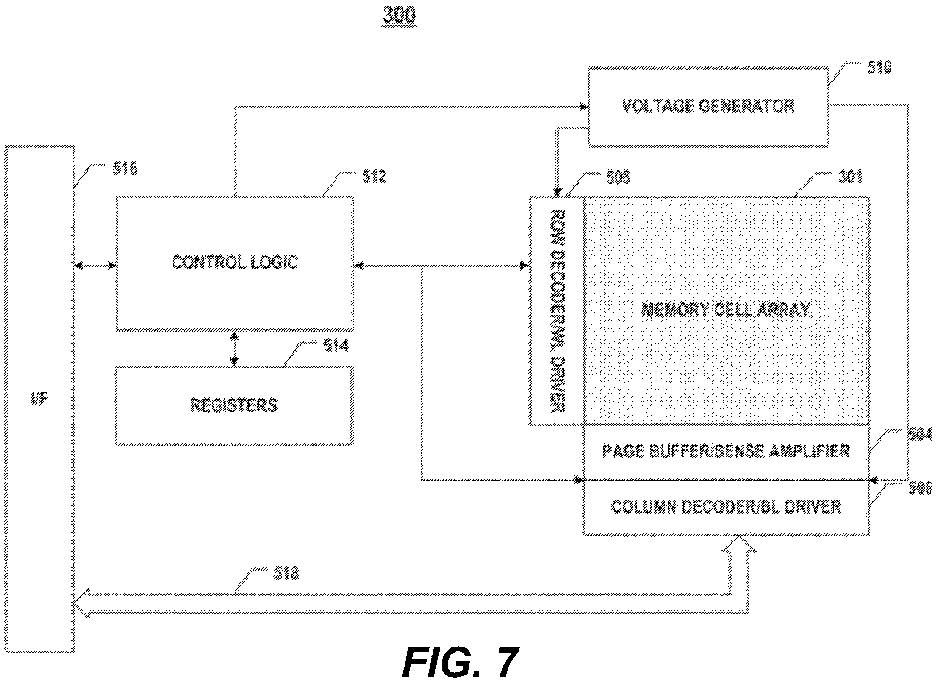

FIG. 7 is a block diagram of a memory device including an array of memory cells and peripheral circuitry according to implementations of the disclosure. The peripheral circuitry can be an example of the peripheral circuitry 302 and can include page buffers/sense amplifiers 504, column decoders/bit line drivers 506, row decoders/word line drivers 508, voltage generators 510, control logic 512, registers 514, interfaces 516, and data bus 518. In an example, additional circuits not shown in FIG. 7 can also be included.

The page buffer/sense amplifier 504 can be configured to read data from the memory cell array 301 and program (write) data to the memory cell array 301 based on a control signal from the control logic 512. In one example, the page buffer/sense amplifier 504 can store a page of program data (write data) to be programmed into one page 320 of the memory cell array 301. In an example, the page buffer/sense amplifier 504 can perform a program verify operation to ensure that data has been properly programmed into the memory cells 306 coupled to the selected word lines 318. In an example, the page buffer/sense amplifier 504 can sense low power signals from the bit lines 316 representing data bits stored in memory cells 306 and amplify small voltage swings to recognizable logic levels in a read operation. The column decoder/bit line driver 506 can be configured to be controlled by the control logic 512 and select one or more NAND memory strings 308 by applying a bit line voltage generated from the voltage generator 510.

The row decoder/word line driver 508 can be configured to be controlled by the control logic 512 and to select/deselect a block 304 of the memory cell array 301 and to select/deselect a word line 318 of the block 304. The row decoder/word line driver 508 can also be configured to drive the word line 318 using the word line voltage generated from the voltage generator 510. In an implementation, the row decoder/word line drivers 508 can also select/deselect and drive the SSG lines 315 and DSG lines 313. As described in detail below, the row decoder/word line driver 508 is configured to perform an erase operation on the memory cells 306 coupled to the selected word line(s) 318. The voltage generator 510 can be configured to be controlled by the control logic 512 and generate a word line voltage (e.g., a read voltage, a program voltage, a pass voltage, a local voltage, a verify voltage, etc.), a bit line voltage, and a source line voltage to be supplied to the memory cell array 301.

The control logic 512 can be coupled to each of the peripheral circuits described above and configured to control the operation of each of the peripheral circuits. The registers 514 can be coupled to the control logic 512 and include a status register, a command register, and an address register for storing status information, a command operation code (OP code), and a command address for controlling the operation of each peripheral circuit. Interface 516 can be coupled to the control logic 512 and act as a control buffer to buffer and relay control commands received from a host (not shown) to the control logic 512 and to buffer and relay status information received from the control logic 512 to the host. The interface 516 can also be coupled to the column decoder/bit line drivers 506 via a data bus 518 and act as a data I/O interface and data buffer to buffer data and relay it to or from the memory cell array 301.

The peripheral circuitry 302 is configured to perform the programming methods provided in this disclosure on selected ones of the plurality of memory cell rows.

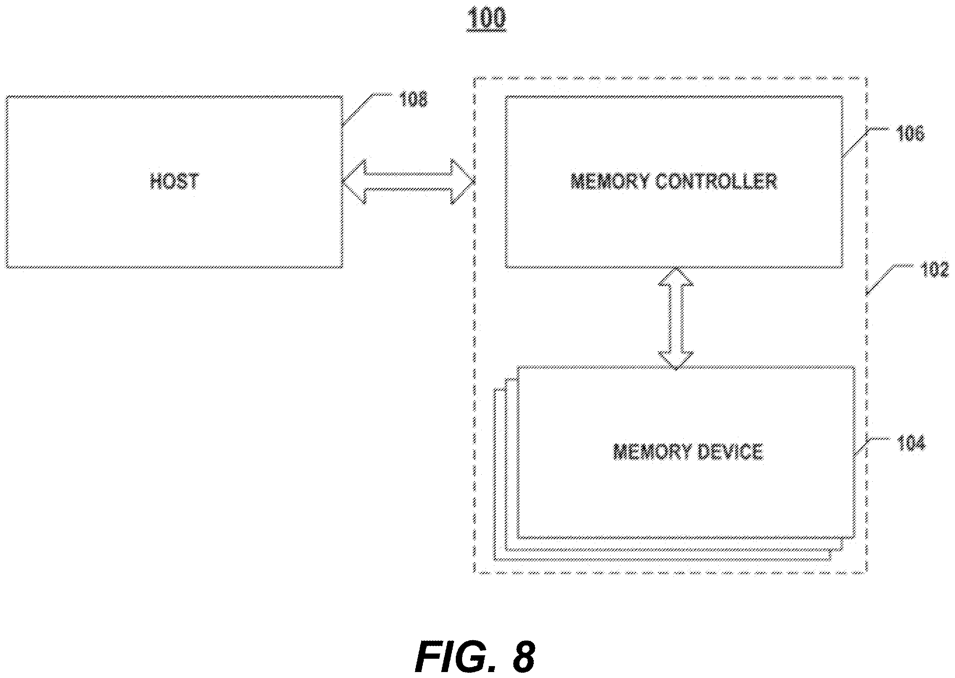

FIG. 8 illustrates a block diagram of an example system 100 with a memory system according to implementations of the disclosure. The system 100 can be a mobile phone, desktop computer, laptop computer, tablet computer, vehicle computer, game console, printer, positioning device, wearable electronic device, smart sensor, virtual reality (VR) device, augmented reality (AR) device, or any other suitable electronic device having storage therein.

As shown in FIG. 8, the system 100 can include a host 108 and a memory system 102. The memory system 102 can have one or more memories 104 and a memory controller 106. The host 108 can be a processor (e.g., a central processing unit (CPU)) or a system on a chip (SoC) (e.g., an application processor (AP)) of an electronic device. The host 108 can be configured to send data to the one or more memories 104 or receive data from the one or more memories 104.

The one or more memories 104 can be any memory device disclosed in the present disclosure, for example, the one or more memories 104 can include the memory device 300 provided by the present disclosure. As disclosed in detail below, the one or more memories 104 (e.g., a NAND flash memory device (e.g., a three-dimensional (3D) NAND flash memory device)) can have reduced leakage current from the drive transistors (e.g., string drivers) coupled to unselected word lines during an erase operation, which allows for further scaling of the drive transistors.

In an implementation, the memory controller 106 is coupled to the one or more memories 104 and the host 108 and is configured to control the one or more memories 104. The memory controller 106 can manage data stored in the one or more memories 104 and communicate with the host 108. The memory controller 106 is configured to control the one or more memories 104 to perform the programming method provided by any of the implementations of the present disclosure.

In an implementation, the memory controller 106 is designed for operation in a low duty cycle environment, such as a secure digital (SD) card, compact flash (CF) card, universal serial bus (USB) flash drive, or other medium for use in electronic devices such as personal computers, digital cameras, mobile phones, and so forth.

In an implementation, the memory controller 106 is designed for operation in a high duty cycle environment SSD or embedded multimedia card (eMMC) that is used as a data store and enterprise storage array for mobile devices such as smart phones, tablet computers, laptop computers, and the like. The memory controller 106 can be configured to control operations of the memory device 104, such as read, erase, and program operations. The memory controller 106 can also be configured to manage various functions with respect to data stored or to be stored in the memory device 104, including but not limited to bad block management, garbage collection, logical to physical address translation, wear leveling, and the like.

In an implementation, the memory controller 106 is configured to process ECC with respect to data read from the memory device 104 or written to the memory device 104. The memory controller 106 can also perform any other suitable functions, such as formatting the memory device 104. The memory controller 106 can communicate with external devices (e.g., the host 108) according to a particular communication protocol. For example, the memory controller 106 can communicate with the external device via at least one of various interface protocols, such as a USB protocol, an MMC protocol, a peripheral component interconnect (PCI) protocol, a PCI express (PCI-E) protocol, an advanced technology attachment (ATA) protocol, a serial ATA protocol, a parallel ATA protocol, a small computer system small interface (SCSI) protocol, an enhanced small disk interface (ESDI) protocol, an integrated drive electronics (IDE) protocol, a firewire protocol, and so forth.

The memory controller 106 and the one or more memories 104 can be integrated into various types of storage devices, for example, included in the same package (e.g., a Universal Flash Storage (UFS) package or an eMMC package). The memory system 102 can be implemented and packaged into different types of end electronics.

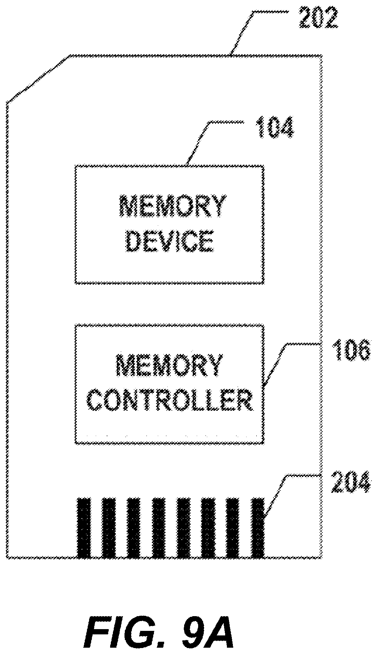

FIG. 9A is a schematic diagram of a memory card 202 according to implementations of the disclosure. The memory controller 106 and the single memory device 104 can be integrated into the memory card 202. The memory card 202 can be a PC card (PCMCIA), a CF card, a smart media (SM) card, a memory stick, a multimedia card (MMC, RS-MMC, MMCmicro), an SD card (SD, miniSD, microSD, SDHC), a UFS, or the like. The memory card 202 can also include a memory card connector 204 that couples memory card 202 with a host (e.g., the host 108 in FIG. 8).

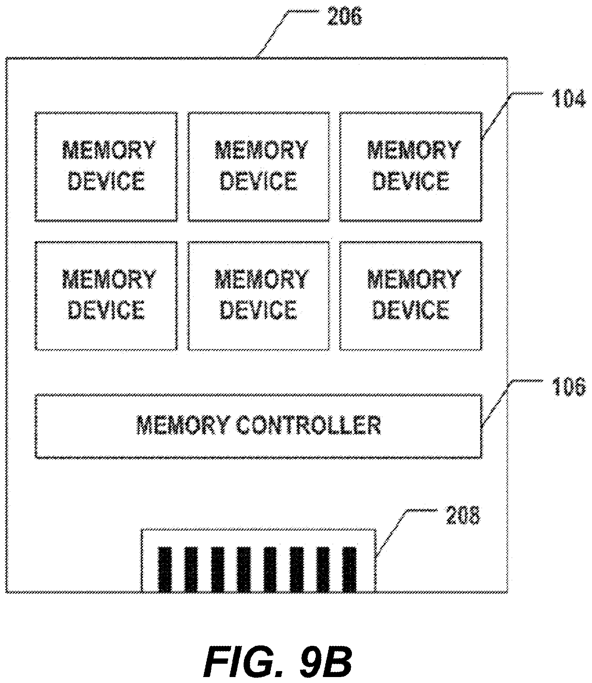

FIG. 9B is a schematic diagram of a solid state drive (SSD) 206 according to implementations of the disclosure. The memory controller 106 and the one or more memories 104 can be integrated into the SSD 206. The SSD 206 can also include a solid state drive connector 208 that couples the SSD 206 with a host (e.g., the host 108 in FIG. 8). In an implementation, the storage capacity and/or operating speed of the SSD 206 is greater than the storage capacity and/or operating speed of the memory card 202.

The above description of the memory device implementations, similar to the above description of the method implementations, has similar advantageous effects as the method implementations. For technical details not disclosed in the implementations of the memory device of the present disclosure, reference is made to the description of the implementations of the method of the present disclosure.

It should be appreciated that reference throughout this specification to "some implementations" means that a particular feature, structure, or characteristic described in connection with the implementations is included in at least one implementation of the present disclosure. Thus, the appearances of the phrases "in some implementations" or "in other implementations" in various places throughout this specification are not necessarily all referring to the same implementation. Furthermore, the particular features, structures, or characteristics may be combined in any suitable manner in one or more implementations. It should be understood that, in various implementations of the present disclosure, the sequence numbers of the above-mentioned processes do not imply an order of execution, and the order of execution of the processes should be determined by their functions and inherent logic and should not constitute any limitation to the implementation process of the implementations of the present disclosure. The above-mentioned serial numbers of the implementations of the present disclosure are merely for description and do not represent the merits of the implementations.

It should be noted that, in this document, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. Without further limitation, an element defined by the phrase "comprising an ......" does not exclude the presence of other like elements in a process, method, article, or apparatus that comprises the element.

In the several implementations provided in the present disclosure, it should be understood that the disclosed apparatus and method may be implemented in other ways. The above-described device implementations are merely illustrative, for example, the division of the unit is only a logical functional division, and there may be other division ways in actual implementation, such as: multiple units or components may be combined, or may be integrated into another system, or some features may be omitted, or not implemented. In addition, the coupling, direct coupling or communication connection between the components shown or discussed may be through some interfaces, and the indirect coupling or communication connection between the devices or units may be electrical, mechanical or other forms.

The units described as separate parts may or may not be physically separate, and parts displayed as units may or may not be physical units; can be located in one place or distributed on a plurality of network units; some or all of the units can be selected according to actual needs to achieve the purpose of the solution of the implementation.

In addition, all the functional units in the implementations of the present disclosure may be integrated into one processing unit, or each unit may be separately regarded as one unit, or two or more units may be integrated into one unit; the integrated unit can be realized in a form of hardware, or in a form of hardware plus a software functional unit.

In general, the present application also covers the following matters (original claim subject matter of parent application EP appl. no. 23826576.3 as included content. The following matters are also disclosed in combination with the subject matter of the appended claims. Furthermore, the following matters are also disclosed in combination with the features of the above-described embodiments, independent from one another or in combination with one another:
1. A method of programming a memory device, the method comprising:
   applying an N-th programming pulse to a word line coupled to memory cells of the memory device each with a target programming state being an i-th programming state, wherein i and N are positive integers; performing a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage; determining a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage; and
   applying the (N+1)-th programming pulse to the word line, wherein the memory cells are determined to be successfully programmed to the i-th programming state after applying the (N+1)-th programming pulse to the word line, based on the first sub-result indicating that a number of failed bits in the first sub-verification is less than a first preset value.
2. The method of matter 1, wherein the memory cells include at least one of a single-level memory cell or a multi-level memory cell, and the target threshold voltage of the i-th programming state is highest among target threshold voltages of programming states corresponding to the single-level memory cell or the multi-level memory cell.
3. The method of matter 1, wherein the memory cells include at least one of a three-level memory cell or a four-level memory cell, and the target programming states of the memory cells include a lowest programming state, one or more intermediate programming states, and a highest programming state, based on threshold voltages of the programming states, and wherein the i-th programming state is one of the one or more intermediate programming states.
4. The method of matter 1, wherein the performing comprises:
   performing the first sub-verification on the memory cells based on a first sensing duration to obtain the first sub-result; and performing the M-th second sub-verification on the memory cells based on a second sensing duration to obtain the M-th second sub-result, wherein the second sensing duration is greater than the first sensing duration.
5. The method of matter 1, wherein the performing comprises: applying a first sub-verification voltage to the word line to perform the first sub-verification on the memory cells to obtain the first sub-result, wherein the first sub-verification voltage is equal to the preset voltage; and applying a second sub-verification voltage to the word line to perform the M-th second sub-verification on the memory cells to obtain the M-th second sub-result, wherein the second sub-verification voltage is equal to the target threshold voltage.
6. The method of matter 1, wherein the performing includes: applying a first pre-charging voltage to a bit line coupled to the memory cells to perform the first sub-verification on the memory cells based on a preset sensing duration to obtain the first sub-result; and applying a second pre-charging voltage to the bit line to perform the M-th second sub-verification on the memory cells based on the preset sensing duration to obtain the M-th second sub-result, wherein the second pre-charging voltage is greater than the first pre-charging voltage.
7. The method of matter 1, wherein the threshold voltage of each of the first subset of the memory cells is less than the target threshold voltage based on the M-th second sub-result.
8. The method of matter 1, further comprising: determining a second subset of the memory cells to be performed with an (M+1)-th second sub-verification, based on the first sub-result indicating that the number of failed bits in the first sub-verification is greater than or equal to the first preset value; and performing the (M+1)-th second sub-verification on the second subset of the memory cells to obtain an (M+1)-th second sub-result after the (N+1)-th programming pulse is applied, wherein the (M+1)-th second sub-result indicates whether a threshold voltage of each of the second subset of the memory cells is less than the target threshold voltage.
9. The method of matter 8, wherein the threshold voltage of each of the second subset of the memory cells is less than the preset voltage based on the first sub-result.
10. The method of matter 8, further comprising: counting a number of failed bits in the (M+1)-th second sub-verification based on the (M+1)-th second sub-result to obtain a counting result; and determining that the memory cells are successfully programmed to the i-th programming state based on the counting result being less than a second preset value.
11. The method of matter 10, further comprising: determining one or more memory cells of the second subset of the memory cells to be programmed with an (N+2)-th programming pulse, based on the counting result being greater than or equal to the second preset value and a number of the applied programming pulses being less than a maximum number of programing pulses.
12. The method of matter 10, further comprising: determining that the memory cells are unsuccessfully programmed to the i-th programming state based on the counting result being greater than or equal to the second preset value and a number of the applied programming pulses being equal to a maximum number of programming pulses.
13. The method of matter 10, wherein the second preset value is less than or equal to the first preset value.
14. The method of matter 1, wherein the performing comprises: performing the first sub-verification on the memory cells to obtain the first sub-result; determining a third subset of the memory cells to be performed with the M-th second sub-verification, based on the first sub-result; and performing the M-th second sub-verification on the third subset of the memory cells to obtain the M-th second sub-result.
15. The method of matter 1, wherein the performing comprises: performing the M-th second sub-verification on the memory cells to obtain the M-th second sub-result; determining a fourth subset of the memory cells to be performed with the first sub-verification, based on the M-th second sub-result; and performing the first sub-verification on the fourth subset of the memory cells to obtain the first sub-result.
16. The method of matter 1, further comprising: counting the number of failed bits in the first sub-verification during applying the (N+1)-th programming pulse.
17. The method of matter 1, wherein the number of failed bits is within a range allowed by an error correction mechanism.
18. The method of matter 17, wherein the error correction mechanism uses an error correction code.
19. The method of matter 1, further comprising: in response to the first sub-result indicating that the number of failed bits in the first sub-verification is less than the first preset value, determining that a programming verification operation is not performed on the memory cells after applying the (N+1)-th programming pulse.
20. The method of matter 1, wherein the first sub-verification is performed only one time during programming the memory cells to the i-th programming state.
21. A memory device, comprising: a memory cell array including memory cells; and peripheral circuitry coupled to the memory cell array through word lines and configured to apply an N-th programming pulse to the memory cells each with a target programming state being an i-th programming state, wherein i and N are positive integers, perform a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage, determine a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage, and apply the (N+1)-th programming pulse to the word line, wherein the memory cells are determined to be successfully programmed to the i-th programming state after applying the (N+1)-th programming pulse to the word line, based on the first sub-result indicating that a number of failed bits in the first sub-verification is less than a first preset value.
22. The memory device of matter 21, wherein the peripheral circuitry is further configured to: perform the first sub-verification on the memory cells based on a first sensing duration to obtain the first sub-result; and perform the M-th second sub-verification on the memory cells based on a second sensing duration to obtain the M-th second sub-result, wherein the second sensing duration is greater than the first sensing duration.
23. The memory device of matter 21, wherein the peripheral circuitry is further configured to: apply a first sub-verification voltage to the word line to perform the first sub-verification on the memory cells to obtain the first sub-result, wherein the first sub-verification voltage is equal to the preset voltage; and apply a second sub-verification voltage to the word line to perform the M-th second sub-verification on the memory cells to obtain the M-th second sub-result, wherein the second sub-verification voltage is equal to the target threshold voltage.
24. The memory device of matter 21, wherein the peripheral circuitry is further configured to: apply a first pre-charging voltage to a bit line coupled to the memory cells to perform the first sub-verification on the memory cells based on a preset sensing duration to obtain the first sub-result; and apply a second pre-charging voltage to the bit line to perform the M-th second sub-verification on the memory cells based on the preset sensing duration to obtain the M-th second sub-result, wherein the second pre-charging voltage is greater than the first pre-charging voltage.
25. The memory device of matter 21, wherein the threshold voltage of each of the first subset of the memory cells is less than the target threshold voltage based on the M-th second sub-result.
26. The memory device of matter 21, wherein the peripheral circuitry is further configured to: determine a second subset of the memory cells to be performed with an (M+1)-th second sub-verification, based on the first sub-result indicating that the number of failed bits in the first sub-verification is greater than or equal to the first preset value; and perform the (M+1)-th second sub-verification on the second subset of the memory cells to obtain an (M+1)-th second sub-result after the (N+1)-th programming pulse is applied, wherein the (M+1)-th second sub-result indicates whether a threshold voltage of each of the second subset of the memory cells is less than the target threshold voltage.
27. The memory device of matter 21, wherein the peripheral circuitry is further configured to: count the number of failed bits in the first sub-verification during applying the (N+1)-th programming pulse.
28. The memory device of matter 21, wherein the number of failed bits is within a range allowed by an error correction mechanism.
29. The memory device of matter 21, wherein the peripheral circuitry is further configured to: in response to the first sub-result indicating that the number of failed bits in the first sub-verification is less than the first preset value, determine that a programming verification operation is not performed on the memory cells after applying the (N+1)-th programming pulse.
30. A memory system, comprising: a memory device comprising a memory cell array including memory cells, and peripheral circuitry coupled to the memory cell array through word lines and configured to apply an N-th programming pulse to a word line coupled to the memory cells each with a target programming state being an i-th programming state, wherein i and N are positive integers, perform a first sub-verification and an M-th second sub-verification corresponding to the i-th programming state on the memory cells to obtain a first sub-result and an M-th second sub-result, respectively, wherein M is a positive integer, the first sub-result indicates whether a threshold voltage of each of the memory cells is less than a preset voltage, the M-th second sub-result indicates whether the threshold voltage of each of the memory cells is less than a target threshold voltage of the i-th programming state, and wherein the target threshold voltage is greater than the preset voltage, determine a first subset of the memory cells to be programmed with an (N+1)-th programming pulse, based on the M-th second sub-result, wherein a voltage difference between the (N+1)-th programming pulse and the N-th programming pulse is greater than or equal to a voltage difference between the target threshold voltage and the preset voltage, and apply the (N+1)-th programming pulse to the word line, wherein the memory cells are determined to be successfully programmed to the i-th programming state after applying the (N+1) programming pulse to the word line, based on the first sub-result indicating that a number of failed bits in the first sub-verification is less than a first preset value; and a memory controller coupled to the memory device and configured to control the memory device.

The above description is only an implementation of the present disclosure, but the scope of the present disclosure is not limited thereto, and any person skilled in the art can easily think of the changes or substitutions within the technical scope of the present disclosure and shall cover the scope of the present disclosure. Therefore, the protection scope of the present disclosure shall be subject to the protection scope of the claims.

## Claims

1. A method of programming a memory device, the memory device comprising memory cells, the method comprising:
applying an N-th programming pulse to a word line coupled to the memory cells with a target programming state being a programming state, wherein N is a positive integer;
performing a N-th verification on the memory cells, wherein the N-th verification comprises a first sub-verification and an N-th second sub-verification;
applying a (N+1)-th programming pulse to the word line, based on an N-th second sub-result of the N-th second sub-verification;
determining whether to perform a (N+1)-th verification after applying the (N+1)-th programming pulse based on a first sub-result of the first sub-verification.

2. The method of claim 1, wherein performing the N-th verification on the memory cells comprise:
performing the first sub-verification on the memory cells based on a first sensing duration;
performing the N-th second sub-verification on the memory cells based on a second sensing duration, wherein the second sensing duration is greater than the first sensing duration.

3. The method of claim 1, wherein performing the N-th verification on the memory cells comprise:
applying a first sub-verification voltage to the word line to perform the first sub-verification on the memory cells;
applying a second sub-verification voltage to the word line to perform the N-th second sub-verification on the memory cells, wherein the second sub-verification voltage is greater than the first sub-verification voltage.

4. The method of claim 1, wherein performing the N-th verification on the memory cells comprise:
applying a first pre-charging voltage to a bit line coupled to the memory cells to perform the first sub-verification on the memory cells; and
applying a second pre-charging voltage to the bit line to perform the N-th second sub-verification on the memory cells, wherein the second pre-charging voltage is greater than the first pre-charging voltage.

5. The method of claim 1, wherein determining whether to perform the (N+1)-th verification after applying the (N+1)-th programming pulse based on the first sub-result of the first sub-verification comprises:
counting a number of failed bits in the first sub-verification to obtain a first counting result;
determining whether the first counting result is less than a first preset value or not.

6. The method of claim 5, wherein determining whether to perform the (N+1)-th verification after applying the (N+1)-th programming pulse based on the first sub-result of the first sub-verification further comprises:
when the first counting result is less than the first preset value, terminating the programming without performing the (N+1)-th verification.

7. The method of claim 5, wherein determining whether to perform the (N+1)-th verification after applying the (N+1)-th programming pulse based on the first sub-result of the first sub-verification further comprises:
when the first counting result is greater than or equal to the first preset value,
performing the (N+1)-th verification, wherein the (N+1)-th verification comprises a (N+1)-th second sub-verification.

8. The method of claim 7, wherein the method further comprises:
counting a number of failed bits in the (N+1)-th second sub-verification to obtain a second counting result;
determining whether the second counting result is less than a second preset value or not.

9. The method of claim 8, wherein the method further comprises:
when the second counting result is less than the second preset value, terminating the programming.

10. The method of claim 8, wherein the method further comprises:
when the second counting result is greater than or equal to the second preset value, determining whether a number of applied programming pulses reaches a maximum number of applied programming pulses.

11. The method of claim 10, wherein the method further comprises:
when the number of applied programming pulses reaches the maximum number of applied programming pulses, terminating the programming.

12. The method of claim 10, wherein the method further comprises:
when the number of applied programming pulses has not reached the maximum number of applied programming pulses, applying a (N+2)-th programming pulse to the word line.

13. The method of claim 1, wherein the memory cells comprise single-level memory cells.

14. A memory device, comprising:
a memory cell array comprising memory cells; and
peripheral circuitry coupled to the memory cell array through word lines and configured to perform the method of any one of claims 1-13.

15. A memory system, comprising:
a memory device of claim 14; and
a memory controller coupled to the memory device and configured to control the memory device.
